# EUROPEAN PATENT APPLICATION

(11) **EP 4 811 995 A1**
(43) Date of publication of application: **23.09.2026**
(21) Application number: 25201842.9
(22) Date of filing: 12.09.2025
(51) Int. Cl.: H10N 50/10, H10N 50/80, H10N 50/85

(54) **MAGNETIC MEMORY DEVICE**

(30) Priority: 19.03.2025 JP 2025044367
(71) Applicant: Kioxia Corporation, Tokyo (JP)
(72) Inventor: YASUDA, Kasumi, Minato-ku, Tokyo (JP); TAKASHIMA, Rina, Minato-ku, Tokyo (JP); EEH, Youngmin, Minato-ku, Tokyo (JP)
(74) Representative: Hoffmann Eitle

(57) **Abstract**

According to one embodiment, a magnetic memory device includes first and second electrodes (10, 20) and a magnetoresistance effect element (30), which includes first and second magnetic layers (40, 50), an insulating layer (60) between the first and second magnetic layers (40, 50), and a lanthanoid oxide layer (70) between the first electrode (10) and the first magnetic layer (40). The lanthanoid oxide layer (70) contains a lanthanoid element of La, Ce, Pr, Nd, Pm, Sm, Eu, Tb, Dy, Ho, Er, Tm, Yb and Lu, O and a predetermined element of Ru, Rh, Pd, Re, Os and Pt, and includes first and second portions containing the lanthanoid element and O. A concentration of the predetermined element is higher in the first portion (70a) than in the second portion (70b). The second portion (70b) is between the first portion (70a) and the first magnetic layer (40).

## Description

### CROSS-REFERENCE TO RELATED APPLICATIONS

This application is based upon and claims the benefit of priority from Japanese Patent Application No. 2025-044367, filed March 19, 2025.

### FIELD

Embodiments described herein relate generally to a magnetic memory device.

### BACKGROUND

Magnetic memory devices in which a plurality of magnetoresistance effect elements are integrated on a semiconductor substrate have been proposed.

### BRIEF DESCRIPTION OF THE DRAWINGS

FIG. 1 is a cross-sectional view schematically showing a configuration of a magnetic memory device according to the first embodiment.
FIG. 2 is a cross-sectional view schematically showing a first configuration example of the magnetic memory device according to the first embodiment.
FIG. 3 is a cross-sectional view schematically showing a second configuration example of the magnetic memory device according to the first embodiment.
FIG. 4 is a cross-sectional view schematically illustrating a part of a method of manufacturing the magnetic memory device of the second configuration example according to the first embodiment.
FIG. 5 is a cross-sectional view schematically showing a third configuration example of the magnetic memory device according to the first embodiment.
FIG. 6 a cross-sectional view schematically illustrating a part of a method of manufacturing the magnetic memory device of the third configuration example according to the first embodiment.
FIG. 7 is a cross-sectional view schematically showing a configuration of a magnetic memory device according to the second embodiment.
FIG. 8 is a cross-sectional view schematically showing a first configuration example of the magnetic memory device according to the second embodiment.
FIG. 9 is a cross-sectional view schematically showing a second configuration example of the magnetic memory device according to the second embodiment.
FIG. 10 is a cross-sectional view schematically showing a third configuration example of the magnetic memory device according to the second embodiment.

### DETAILED DESCRIPTION

In general, according to one embodiment, a magnetic memory device includes a first electrode, a second electrode, and a magnetoresistance effect element provided between the first electrode and the second electrode. The magnetoresistance effect element includes a first magnetic layer, a second magnetic layer, an insulating layer provided between the first magnetic layer and the second magnetic layer, and a lanthanoid oxide layer provided between the first electrode and the first magnetic layer. The lanthanoid oxide layer contains at least one lanthanoid element selected from lanthanum (La), cerium (Ce), praseodymium (Pr), neodymium (Nd), promethium (Pm), samarium (Sm), europium (Eu), terbium (Tb), dysprosium (Dy), holmium (Ho), erbium (Er), thulium (Tm), ytterbium (Yb), and lutetium (Lu), oxygen (O), and at least one predetermined element selected from ruthenium (Ru), rhodium (Rh), palladium (Pd), rhenium (Re), osmium (Os), and platinum (Pt). The lanthanoid oxide layer includes a first portion and a second portion, each containing the at least one lanthanoid element and oxygen (O), the concentration of the at least one predetermined element is higher in the first portion than in the second portion, and the second portion is located between the first portion and the first magnetic layer.

Embodiments will now be described with reference to the accompanying drawings.

### (First Embodiment)

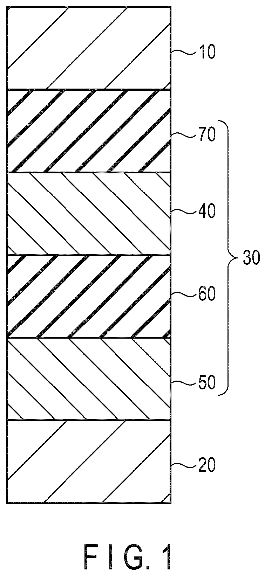

FIG. 1 is a cross-sectional view schematically illustrating a configuration of a magnetic memory device according to the first embodiment.

The magnetic memory device shown in FIG. 1 includes a first electrode 10, a second electrode 20, and a magnetoresistance effect element 30 provided between the first electrode 10 and the second electrode 20. In this embodiment, the first electrode 10 functions as a top electrode of the magnetoresistance effect element 30, and the second electrode 20 functions as a bottom electrode of the magnetoresistance effect element 30.

The magnetoresistance effect element 30 is a spin transfer torque (STT) type magnetic tunnel junction (MTJ) element having perpendicular magnetization, which comprises a storage layer (first magnetic layer) 40, a reference layer (second magnetic layer) 50, a tunnel barrier layer (insulating layer) 60, and a lanthanoid oxide layer 70, and has such a structure in which these layers 40 to 70 are stacked between the first electrode 10 and the second electrode 20.

The first electrode 10 contains at least one element selected, for example, from tungsten (W), tantalum (Ta), tantalum nitride (TaN), titanium (Ti), titanium nitride (TiN), ruthenium (Ru), molybdenum (Mo), and hafnium (Hf).

The second electrode 20 contains at least one element selected, for example, from zirconium (Zr), hafnium (Hf), tungsten (W), chromium (Cr), molybdenum (Mo), niobium (Nb), titanium (Ti), tantalum (Ta), vanadium (V), ruthenium (Ru), and platinum (Pt).

The storage layer 40 is a ferromagnetic layer having a variable magnetization direction. The storage layer 40 contains at least one magnetic element and may further contain boron (B). More specifically, the storage layer 40 contains at least one element selected from iron (Fe), cobalt (Co), and nickel (Ni), and may further contain boron (B). For example, the storage layer 40 may be formed of a CoFeB layer containing Fe, Co, and B.

The reference layer 50 is a ferromagnetic layer having a fixed magnetization direction. The reference layer 50 contains at least one magnetic element and may further contain boron (B). More specifically, the reference layer 50 contains at least one element selected from iron (Fe), cobalt (Co), and nickel (Ni), and may further contain boron (B). For example, the reference layer 50 may be formed of a CoFeB layer containing Fe, Co, and B. The reference layer 50 may further include a superlattice layer of cobalt (Co) and platinum (Pt), in addition to the layer containing magnetic elements and boron (B).

Note that the term "variable magnetization direction" means that the magnetization direction changes with respect to a predetermined write current. Further, the term "fixed magnetization direction" means that the magnetization direction does not change with respect to a predetermined write current.

The tunnel barrier layer 60 is an insulating layer provided between the storage layer 40 and the reference layer 50, and is formed, for example, of an MgO layer containing magnesium (Mg) and oxygen (O).

When the magnetization direction of the storage layer 40 is parallel to the magnetization direction of the reference layer 50, the magnetoresistance effect element 30 is in a low-resistance state, and when the magnetization direction of the storage layer 40 is antiparallel to the magnetization direction of the reference layer 50, the magnetoresistance effect element 30 is in a high-resistance state. Therefore, the magnetoresistance effect element 30 can store binary data according to its resistance state.

A lanthanoid oxide layer 70 is provided between the first electrode 10 and the storage layer 40. In this embodiment, the lanthanoid oxide layer 70 is provided on the upper layer side of the storage layer 40, and the first electrode 10 is provided on the upper layer side of the lanthanoid oxide layer 70. The lanthanoid oxide layer 70 functions as a cap layer.

The lanthanoid oxide layer 70 contains at least one lanthanoid element selected from lanthanum (La), cerium (Ce), praseodymium (Pr), neodymium (Nd), promethium (Pm), samarium (Sm), europium (Eu), terbium (Tb), dysprosium (Dy), holmium (Ho), erbium (Er), thulium (Tm), ytterbium (Yb), and lutetium (Lu), oxygen (O), and at least one predetermined element (at least one additive element) selected from ruthenium (Ru), rhodium (Rh), palladium (Pd), rhenium (Re), osmium (Os), and platinum (Pt).

For example, when at least one lanthanoid element is represented by Ln and at least one predetermined element is represented by X, the lanthanoid oxide layer 70 is represented as Ln2-aXaO3 layer (0 < a < 2). Note here the value of "a" is not constant within the lanthanoid oxide layer 70, as will be described later.

The lanthanoid oxide layer 70 may further contain at least one element selected from iron (Fe), cobalt (Co), boron (B), and nickel (Ni).

The concentration of at least one predetermined element in the lanthanoid oxide layer 70 is higher on the side of the first electrode 10 than on the side of the storage layer 40. In other words, the concentration of at least one predetermined element in the lanthanoid oxide layer 70 is higher in the region close to the first electrode 10 than in the region close to the storage layer 40. Specifically, it is preferable that the concentration of at least one predetermined element is substantially zero in the region close to the interface between the storage layer 40 and the lanthanoid oxide layer 70. That is, it is preferable that the concentration of at least one predetermined element is zero or so low to such a degree as to be negligible.

The average concentration of at least one predetermined element in the entire lanthanoid oxide layer 70 is preferably in a range of 1 at% to 50 at%.

Further, the thickness of the lanthanoid oxide layer 70 is preferably in a range of 0.6 nm to 3.0 nm.

As described above, in this embodiment, a lanthanoid oxide layer 70 containing at least one predetermined element is provided between the first electrode 10 and the storage layer 40. With this configuration, it is possible to obtain a magnetic memory device including a magnetoresistance effect element having excellent characteristics, as will be described below.

Generally, the storage layer is formed by crystallizing a storage layer in an amorphous state, containing magnetic elements and boron through thermal treatment. Specifically, boron diffuses by thermal treatment, and therefore the amorphous storage layer crystallizes to form a crystallized storage layer.

Further, lanthanoid oxides have large lattice spacings. Therefore, with a lanthanoid oxide layer thus provided adjacent to the amorphous storage layer, the lanthanoid oxide layer can effectively absorb boron during the crystallization process induced by thermal treatment.

However, lanthanoid oxides are essentially insulators. Therefore, when the thickness of the lanthanoid oxide layer is thick, the resistance of the lanthanoid oxide layer increases, leading to a decrease in the tunnel magnetoresistance ratio (TMR ratio). On the other hand, when the thickness of the lanthanoid oxide layer is thin, agglomeration occurs, thereby making it difficult to obtain an appropriate lanthanoid oxide layer.

In the present embodiment, by providing a lanthanoid oxide layer 70 containing at least one predetermined element adjacent to the storage layer 40, it is possible to suppress such drawbacks as described above.

When a predetermined element selected from Ru, Rh, Pd, Re, Os, and Pt is added to the lanthanoid oxide, an intermediate gap state is formed near the Fermi level EF due to the predetermined element. By allowing current to flow within the lanthanoid oxide through the intermediate gap state, the resistance of the lanthanoid oxide can be reduced.

As described above, in this embodiment, with the lanthanoid oxide layer 70 containing at least one predetermined element thus provided, it is possible to form a lanthanoid oxide layer 70 having a certain thickness and a low resistance value, between the first electrode 10 and the storage layer 40. With this configuration, a magnetoresistance effect element having excellent characteristics can be obtained.

Furthermore, in this embodiment, the concentration of at least one predetermined element in the lanthanoid oxide layer 70 is higher on the side of the first electrode 10 than on the side of the storage layer 40. That is, the concentration of at least one predetermined element in the lanthanoid oxide layer 70 is lower in the region close to the interface between the storage layer 40 and the lanthanoid oxide layer 70.

When the concentration of the predetermined element is high in the region close to the interface between the storage layer 40 and the lanthanoid oxide layer 70, the damping constant of the storage layer 40 may increase due to the energy levels formed by the addition of predetermined element. In this embodiment, the concentration of at least one predetermined element is lower in the region close to the interface between the storage layer 40 and the lanthanoid oxide layer 70, it is possible to suppress an increase in the damping constant of the storage layer 40.

Further, it is preferable that a good bond between a magnetic element such as iron (Fe) and oxygen (O) should be formed at the interface between the storage layer 40 and the lanthanoid oxide layer 70. When the concentration of the predetermined element is high in the region close to the interface between the storage layer 40 and the lanthanoid oxide layer 70, the good bond between the magnetic element and oxygen may be impaired by the predetermined element. In this embodiment, the concentration of at least one predetermined element is low in the region close to the interface between the storage layer 40 and the lanthanoid oxide layer 70, thereby making it possible to secure the good bond between the magnetic element and oxygen.

Next, a specific configuration example of the magnetic memory device according to this embodiment will be described. Note that the following configuration example shows only the first electrode 10, the storage layer 40, and the lanthanoid oxide layer 70, but on the lower layer side of the storage layer 40, there are the tunnel barrier layer 60, the reference layer 50, and the second electrode 20 shown in FIG. 1 are provided.

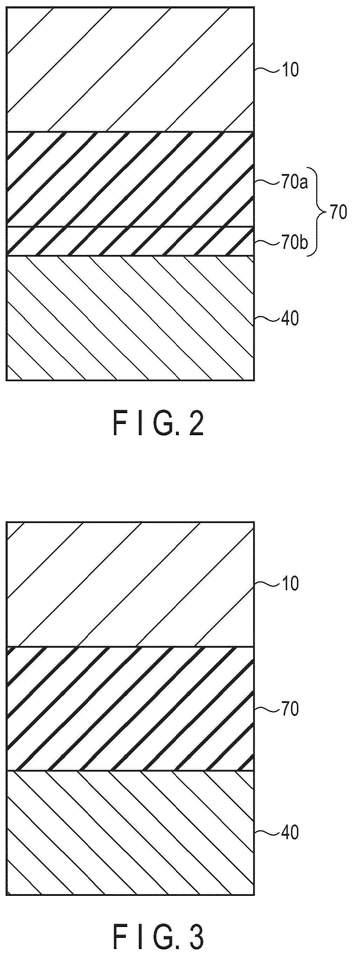

FIG. 2 is a cross-sectional view schematically showing the first configuration example of the present embodiment.

In this configuration example, the lanthanoid oxide layer 70 includes a first layer portion 70a and a second layer portion 70b provided between the storage layer 40 and the first layer portion 70a.

The first layer portion 70a is formed of a lanthanoid oxide containing at least one of the lanthanoid elements listed above, oxygen (O), and at least one predetermined element.

The second layer portion 70b is formed of a lanthanoid oxide containing at least one of the lanthanoid elements listed above, oxygen (O), and substantially no predetermined element. That is, the concentration of at least one of the predetermined elements in the second layer portion 70b is zero or low to such a degree as to be negligible. The thickness of the second layer portion 70b is less than that of the first layer portion 70a and should preferably be in a range from 0.3 nm to 0.8 nm.

FIG. 3 is a cross-sectional view schematically illustrating the second configuration example of the present embodiment.

In this configuration example, the concentration of at least one predetermined element in the lanthanoid oxide layer 70 increases from the storage layer 40 side toward the first electrode 10 side. Such a configuration can be formed, for example, in the following manner.

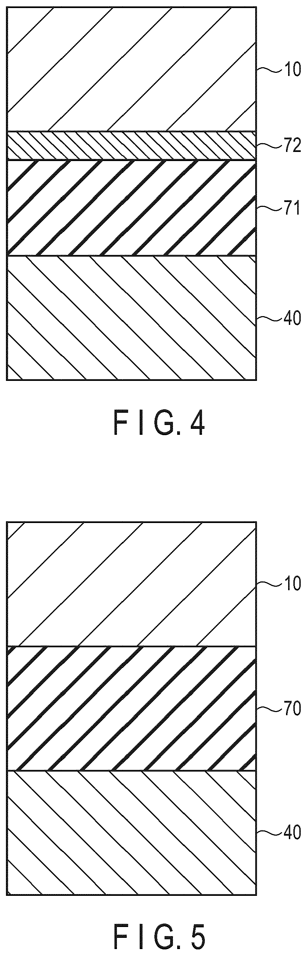

First, as shown in FIG. 4, between the first electrode 10 and the storage layer 40, a structure including a lanthanoid oxide layer 71 that does not contain the predetermined element and a predetermined element-containing layer 72 that contains at least one of the predetermined elements, is formed.

By performing thermal treatment on the structure described above, interdiffusion occurs between the lanthanoid oxide layer 71 and the predetermined element-containing layer 72. With this process, a lanthanoid oxide layer 70 having such a concentration gradient as described above can be formed.

FIG. 5 is a cross-sectional view schematically showing the third configuration example of the present embodiment.

In this configuration example, as in the case of the second configuration example described above, the concentration of at least one predetermined element in the lanthanoid oxide layer 70 increases from the storage layer 40 side toward the first electrode 10 side. Further, in this configuration example, the first electrode 10 contains at least one predetermined element. Such a structure can be formed, for example, in the following manner.

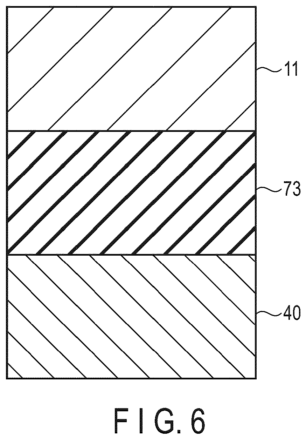

First, as shown in FIG. 6, a structure including a lanthanoid oxide layer 73 that does not contain a predetermined element is formed between the preliminary first electrode 11 and the storage layer 40. For the preliminary first electrode 11, a material containing at least one predetermined element is used. For example, the preliminary first electrode 11 may be made of a material in which at least one predetermined element is added to the main electrode material, or it may be made of a material formed solely from at least one predetermined element.

By performing thermal treatment on such a structure as described above, at least one predetermined element from the preliminary first electrode 11 diffuses into the lanthanoid oxide layer 73. In this manner, the lanthanoid oxide layer 70 having such a concentration gradient as described above can be formed.

According to the first, second, and third configuration examples, it is possible to obtain an excellent magnetoresistance effect element having the advantageous effects described above.

### (Second Embodiment)

Next, the second embodiment will be described. Note that the basic items are similar to those of the first embodiment, and the explanation of the items described in the first embodiment will be omitted.

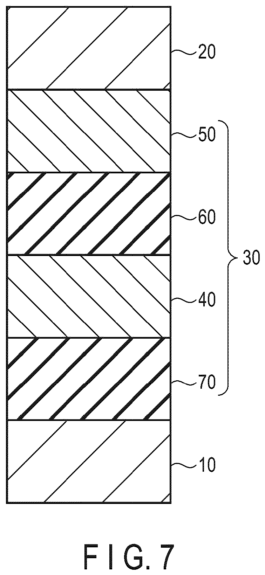

FIG. 7 is a cross-sectional view schematically illustrating a configuration of a magnetic memory device according to the second embodiment.

In this embodiment, as in the case of the first embodiment, a magnetoresistance effect element 30 is provided between the first electrode 10 and the second electrode 20, and the lanthanoid oxide layer 70 is provided between the first electrode 10 and the storage layer 40.

Note that, in this embodiment, the stacking order of the first electrode 10, the second electrode 20, the storage layer 40, the reference layer 50, the tunnel barrier layer 60, and the lanthanoid oxide layer 70 is reversed compared to that of the first embodiment. Therefore, in this embodiment, the first electrode 10 functions as the bottom electrode of the magnetoresistance effect element 30, and the second electrode 20 functions as the top electrode of the magnetoresistance effect element 30. Further, in this embodiment, the lanthanoid oxide layer 70 is provided on the lower side of the storage layer 40, and the first electrode 10 is provided on the lower side of the lanthanoid oxide layer 70. Note that the lanthanoid oxide layer 70 functions as an under layer.

In this embodiment, as in the case of the first embodiment, the lanthanoid oxide layer 70, which contains at least one predetermined element selected from Ru, Rh, Pd, Re, Os, and Pt, is provided between the first electrode 10 and the storage layer 40. Therefore, in this embodiment as well, advantageous effects similar to those of the first embodiment can be obtained.

Next, a specific configuration example of a magnetic memory device according to this embodiment will be described. Note that in the following configuration example, only the first electrode 10, the storage layer 40, and the lanthanoid oxide layer 70 are shown, but on the upper side of the storage layer 40, the tunnel barrier layer 60, the reference layer 50, and the second electrode 20 shown in FIG. 7 are provided.

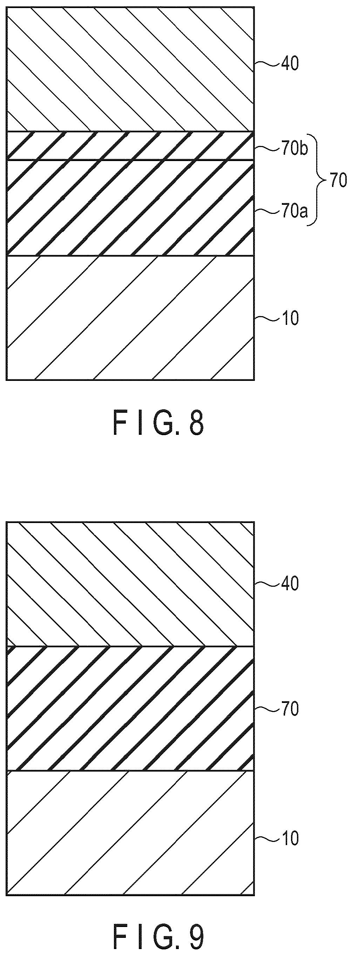

FIG. 8 is a cross-sectional view schematically showing the first configuration example of the present embodiment.

The basic configuration of this configuration example is similar to that of the first configuration example of the first embodiment. That is, the lanthanoid oxide layer 70 includes a first layer portion 70a and a second layer portion 70b provided between the storage layer 40 and the first layer portion 70a. Note that the basic configuration of the first layer portion 70a and the second layer portion 70b is similar to that of the first configuration example of the first embodiment.

FIG. 9 is a cross-sectional view schematically illustrating the second configuration example of the present embodiment.

The basic configuration of this configuration example is similar to that of the second configuration example of the first embodiment. That is, the concentration of at least one predetermined element in the lanthanoid oxide layer 70 increases from the storage layer 40 side toward the first electrode 10 side. The basic formation method of this configuration example is similar to that of the second configuration example of the first embodiment.

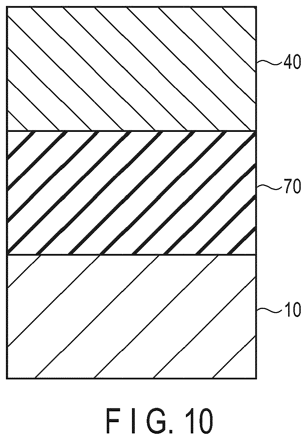

FIG. 10 is a cross-sectional view schematically showing the third configuration example of this embodiment.

The basic configuration of this configuration example is similar to that of the third configuration example of the first embodiment. That is, the concentration of at least one predetermined element in the lanthanoid oxide layer 70 increases from the storage layer 40 side toward the first electrode 10 side, and the first electrode 10 contains at least one predetermined element. The basic formation method of this configuration example is similar to that of the third configuration example of the first embodiment.

According to the first, second, and third configuration examples, it is possible to obtain an excellent magnetoresistance effect element having the above-described advantageous effects.

The arrangements as described above include clauses below.

### Clause 1

A magnetic memory device comprising:
a first electrode (10);
a second electrode (20); and
a magnetoresistance effect element (30) provided between the first electrode (10) and the second electrode (20),
wherein
the magnetoresistance effect element (30) comprises:
   a first magnetic layer (40);
   a second magnetic layer (50);
   an insulating layer (60) provided between the first magnetic layer (40) and the second magnetic layer (50); and
   a lanthanoid oxide layer (70) provided between the first electrode (10) and the first magnetic layer (40), and
   the lanthanoid oxide layer (70) contains at least one lanthanoid element selected from lanthanum (La), cerium (Ce), praseodymium (Pr), neodymium (Nd), promethium (Pm), samarium (Sm), europium (Eu), terbium (Tb), dysprosium (Dy), holmium (Ho), erbium (Er), thulium (Tm), ytterbium (Yb), and lutetium (Lu), oxygen (O), and at least one predetermined element selected from ruthenium (Ru), rhodium (Rh), palladium (Pd), rhenium (Re), osmium (Os), and platinum (Pt),
   the lanthanoid oxide layer (70) includes a first portion (70a) and a second portion (70b), each containing the at least one lanthanoid element and oxygen (O), and a concentration of the at least one predetermined element is higher in the first portion (70a) than in the second portion (70b), and the second portion (70b) is located between the first portion (70a) and the first magnetic layer (40).

### Clause 2

The device of Clause 1, wherein
the lanthanoid oxide layer (70) further contains boron (B).

### Clause 3

The device of Clause 1, wherein
the lanthanoid oxide layer (70) further contains at least one element selected from iron (Fe), cobalt (Co), and nickel (Ni).

### Clause 4

The device of Clause 1, wherein
the second portion (70b) is in contact with the first magnetic layer (40).

### Clause 5

The device of Clause 1, wherein
a thickness of the second portion (70b) is less than a thickness of the first portion (70a).

### Clause 6

The device of Clause 1, wherein
a thickness of the second portion (70b) is in a range of 0.3 nm to 0.8 nm.

### Clause 7

The device of Clause 1, wherein
the concentration of the at least one predetermined element in the lanthanoid oxide layer (70) increases from a side of the first magnetic layer (40) toward a side of the first electrode (10).

### Clause 8

The device of Clause 1, wherein
a thickness of the lanthanoid oxide layer (70) is in a range of 0.6 nm to 3.0 nm.

### Clause 9

The device of Clause 1, wherein
the first electrode (10) contains the at least one predetermined element.

### Clause 10

The device of Clause 1, wherein
the first magnetic layer (40) has a variable magnetization direction, and the second magnetic layer (50) has a fixed magnetization direction.

### Clause 11

The device of Clause 1, wherein
the first magnetic layer (40) contains a magnetic element and boron (B),
   and/or
the first magnetic layer (40) contains at least one element selected from iron (Fe), cobalt (Co), and nickel (Ni), and boron (B).

### Clause 12

The device of Clause 1, wherein
the lanthanoid oxide layer (70) is provided on an upper layer side of the first magnetic layer (40).

### Clause 13

The device of Clause 1, wherein
the lanthanoid oxide layer (70) is provided on a lower layer side of the first magnetic layer (40).

### Clause 14

The device of Clause 1, wherein
when the at least one lanthanoid element is represented by Ln and the at least one predetermined element is represented by X, the lanthanoid oxide layer (70) is represented by Ln2-aXaO3 layer, where a relation of 0 < a < 2 is satisfied.

### Clause 15

The device of Clause 1, wherein
the second portion (70b) does not contain the at least one predetermined element.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A magnetic memory device comprising:
a first electrode (10);
a second electrode (20); and
a magnetoresistance effect element (30) provided between the first electrode (10) and the second electrode (20),
wherein
the magnetoresistance effect element (30) comprises:
a first magnetic layer (40);
a second magnetic layer (50);
an insulating layer (60) provided between the first magnetic layer (40) and the second magnetic layer (50); and
a lanthanoid oxide layer (70) provided between the first electrode (10) and the first magnetic layer (40), and
the lanthanoid oxide layer (70) contains at least one lanthanoid element selected from lanthanum (La), cerium (Ce), praseodymium (Pr), neodymium (Nd), promethium (Pm), samarium (Sm), europium (Eu), terbium (Tb), dysprosium (Dy), holmium (Ho), erbium (Er), thulium (Tm), ytterbium (Yb), and lutetium (Lu), oxygen (O), and at least one predetermined element selected from ruthenium (Ru), rhodium (Rh), palladium (Pd), rhenium (Re), osmium (Os), and platinum (Pt),
the lanthanoid oxide layer (70) includes a first portion (70a) and a second portion (70b), each containing the at least one lanthanoid element and oxygen (O), and a concentration of the at least one predetermined element is higher in the first portion (70a) than in the second portion (70b), and the second portion (70b) is located between the first portion (70a) and the first magnetic layer (40).

2. The device of claim **1,** wherein
the lanthanoid oxide layer (70) further contains boron (B).

3. The device of claim 1 or 2, wherein
the lanthanoid oxide layer (70) further contains at least one element selected from iron (Fe), cobalt (Co), and nickel (Ni).

4. The device of any one of the preceding claims, wherein
the second portion (70b) is in contact with the first magnetic layer (40).

5. The device of any one of the preceding claims, wherein
a thickness of the second portion (70b) is less than a thickness of the first portion (70a).

6. The device of any one of the preceding claims, wherein
a thickness of the second portion (70b) is in a range of 0.3 nm to 0.8 nm.

7. The device of any one of the preceding claims, wherein
the concentration of the at least one predetermined element in the lanthanoid oxide layer (70) increases from a side of the first magnetic layer (40) toward a side of the first electrode (10).

8. The device of any one of the preceding claims, wherein
a thickness of the lanthanoid oxide layer (70) is in a range of 0.6 nm to 3.0 nm.

9. The device of any one of the preceding claims, wherein
the first electrode (10) contains the at least one predetermined element.

10. The device of any one of the preceding claims, wherein
the first magnetic layer (40) has a variable magnetization direction, and the second magnetic layer (50) has a fixed magnetization direction.

11. The device of any one of the preceding claims, wherein
the first magnetic layer (40) contains a magnetic element and boron (B),
and/or
the first magnetic layer (40) contains at least one element selected from iron (Fe), cobalt (Co), and nickel (Ni), and boron (B).

12. The device of any one of the preceding claims, wherein
the lanthanoid oxide layer (70) is provided on an upper layer side of the first magnetic layer (40).

13. The device of any one of the preceding claims, wherein
the lanthanoid oxide layer (70) is provided on a lower layer side of the first magnetic layer (40).

14. The device of any one of the preceding claims, wherein
when the at least one lanthanoid element is represented by Ln and the at least one predetermined element is represented by X, the lanthanoid oxide layer (70) is represented by Ln2-aXaO3 layer, where a relation of 0 < a < 2 is satisfied.

15. The device of any one of the preceding claims, wherein
the second portion (70b) does not contain the at least one predetermined element.
